# EUROPEAN PATENT APPLICATION

(11) **EP 4 016 653 A1**
(43) Date of publication of application: **22.06.2022**
(21) Application number: 21196006.7
(22) Date of filing: 10.09.2021
(51) Int. Cl.: H01L 49/02

(54) **METAL INSULATOR METAL (MIM) CAPACITOR WITH PEROVSKITE DIELECTRIC**

(30) Priority: 21.12.2020 US 202017129854
(71) Applicant: Intel Corporation, Santa Clara, CA 95054 (US)
(72) Inventor: Lin, Chia-Ching, Portland, 97229 (US); Chang, Sou-Chi, Portland, 97229 (US); Oguz, Kaan, Beaverton, 97006 (US); Tung, I-Cheng, Hillsboro, 97124 (US); Sen, Gupta Amab, Hillsboro, 97124 (US); Young, Ian A., Portland, 97229 (US); Avci, Uygar, Portland, 97225 (US); Metz, Matthew, Portland, 97229 (US); Penumatcha, Ashish Verma, Beaverton, 97003 (US); Roy, Anandi, Hillsboro, 97124 (US)
(74) Representative: Goddar, Heinz J.

(57) **Abstract**

Metal insulator metal capacitors are described. In an example, a metal-insulator-metal (MIM) capacitor includes a first electrode plate, and a first capacitor dielectric on the first electrode plate. The first capacitor dielectric is or includes a perovskite high-k dielectric material. A second electrode plate is on the first capacitor dielectric and has a portion over and parallel with the first electrode plate, and a second capacitor dielectric is on the second electrode plate. A third electrode plate is on the second capacitor dielectric and has a portion over and parallel with the second electrode plate.

## Description

### TECHNICAL FIELD

Embodiments of the disclosure are in the field of advanced integrated circuit structure fabrication and, in particular, metal insulator metal (MIM) capacitors.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and currently known fabrication processes may limit the possibility to further extend them into smaller and smaller nodes. Consequently, fabrication of the functional components needed for future technology nodes may require the introduction of new methodologies or the integration of new technologies in current fabrication processes or in place of current fabrication processes.

### BRIEF DESCRIPTION OF THE DRAWINGS

Figure 1 illustrates a schematic and corresponding cross-sectional view of an on-die MIM in a power delivery system, in accordance with an embodiment of the present disclosure.
Figure 2A illustrates a cross-sectional view of a two-plate MIM structure between two top (BEOL) metal layers.
Figure 2B illustrates a cross-sectional view of an atomic layer deposition (ALD) HfOx-based multiple-plate MIM structure.
Figure 3 illustrates a PVD perovskite-based multiple-plate decoupling capacitor, in accordance with an embodiment of the present disclosure.
Figure 4 illustrates another PVD perovskite-based multiple-plate decoupling capacitor, in accordance with another embodiment of the present disclosure.
Figure 5 illustrates another PVD perovskite-based multiple-plate decoupling capacitor, in accordance with another embodiment of the present disclosure.
Figure 6 illustrates a hybrid PVD perovskite-based and ALD non-perovskite-based multiple-plate decoupling capacitor, in accordance with an embodiment of the present disclosure.
Figure 7 illustrates a cross-sectional view of an integrated circuit structure having four metallization layers with a metal line composition and pitch above two metallization layers with a differing metal line composition and smaller pitch, in accordance with an embodiment of the present disclosure.
Figure 8 illustrates a computing device in accordance with one implementation of the disclosure.
Figure 9 illustrates an interposer that includes one or more embodiments of the disclosure.
Figure 10 is an isometric view of a mobile computing platform employing an IC fabricated according to one or more processes described herein or including one or more features described herein, in accordance with an embodiment of the present disclosure.
Figure 11 illustrates a cross-sectional view of a flip-chip mounted die, in accordance with an embodiment of the present disclosure.

### DESCRIPTION OF THE EMBODIMENTS

Metal insulator metal (MIM) capacitors are described. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

The following detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

Terminology. The following paragraphs provide definitions or context for terms found in this disclosure (including the appended claims):

"Comprising." This term is open-ended. As used in the appended claims, this term does not foreclose additional structure or operations.

"Configured To." Various units or components may be described or claimed as "configured to" perform a task or tasks. In such contexts, "configured to" is used to connote structure by indicating that the units or components include structure that performs those task or tasks during operation. As such, the unit or component can be said to be configured to perform the task even when the specified unit or component is not currently operational (e.g., is not on or active). Reciting that a unit or circuit or component is "configured to" perform one or more tasks is expressly intended not to invoke 35 U.S.C. §112, sixth paragraph, for that unit or component.

"First," "Second," etc. As used herein, these terms are used as labels for nouns that they precede, and do not imply any type of ordering (e.g., spatial, temporal, logical, etc.).

"Coupled" - The following description refers to elements or nodes or features being "coupled" together. As used herein, unless expressly stated otherwise, "coupled" means that one element or node or feature is directly or indirectly joined to (or directly or indirectly communicates with) another element or node or feature, and not necessarily mechanically.

In addition, certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", "side", "outboard", and "inboard" describe the orientation or location or both of portions of the component within a consistent but arbitrary frame of reference which is made clear by reference to the text and the associated drawings describing the component under discussion. Such terminology may include the words specifically mentioned above, derivatives thereof, and words of similar import.

"Inhibit" - As used herein, inhibit is used to describe a reducing or minimizing effect. When a component or feature is described as inhibiting an action, motion, or condition it may completely prevent the result or outcome or future state completely. Additionally, "inhibit" can also refer to a reduction or lessening of the outcome, performance, or effect which might otherwise occur. Accordingly, when a component, element, or feature is referred to as inhibiting a result or state, it need not completely prevent or eliminate the result or state.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back end of line (BEOL) semiconductor processing and structures. BEOL is the second portion of IC fabrication where the individual devices (e.g., transistors, capacitors, resistors, etc.) get interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

In accordance with one or more embodiments of the present disclosure, a metal insulator metal (MIM) capacitor is described. One or more embodiments are directed to perovskite-based multiple-plate decoupling capacitors. One or more embodiments are directed to hybrid physical vapor deposited (PVD) perovskite based and atomic layer deposited (ALD) based decoupling capacitor structures. Embodiments can be implemented to increase capacitance of a MIM capacitor while meeting reliability specifications.

To provide context, higher on-die metal-insulator-metal (MIM) capacitance density is needed to minimize first droop during load switching. An on-die MIM is typically located between the two top metal layers and, as such, the capacitance is a backend decouple capacitance and process temperatures may need to be lower than 400 degrees Celsius. A high-k insulating material in stat-of-the-art MIM structures can be fabricated using ALD HfOx-based high-k material, such as Hf-Al-Ox and Hf-Zr-Ox. However, the upper limit of the dielectric constant of ALD HfOx-based high-k material is about 40.

In accordance with embodiments of the present disclosure, perovskite-based high-k materials are used to achieve a dielectric constant larger than 150 and result in greater than 2x MIM charge density boost versus stat-of-the-art MIM structures. However, the process integration and structure of perovskite-based high-k MIM can be different than for ALD HfOx-based MIM structures. In accordance with one or more embodiments described herein, perovskite-based multiple-plate decoupling capacitor integration structures are described.

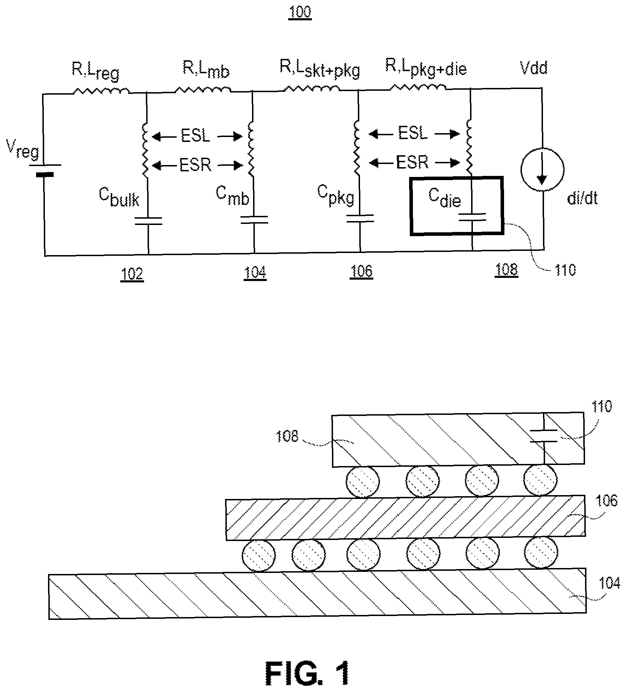

As an exemplary implementation of MIM structures described herein, Figure 1 illustrates a schematic and corresponding cross-sectional view of an on-die MIM in a power delivery system, in accordance with an embodiment of the present disclosure. Referring to Figure 1, a power delivery system 100 includes a regulator 102, a board 104, a package (or package substrate) 106, a die 108, and an on-die MIM capacitor 110.

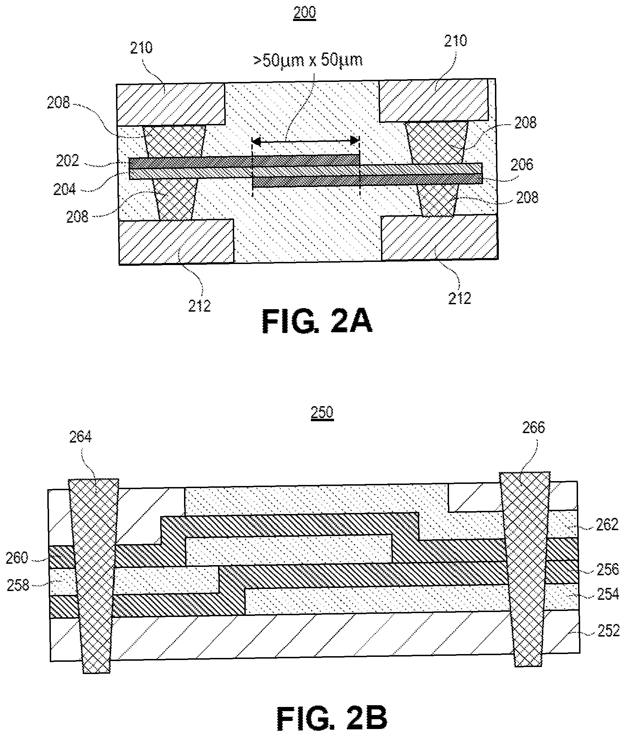

To provide background for embodiments described herein, Figure 2A illustrates a cross-sectional view of a two-plate MIM structure between two top (BEOL) metal layers. Referring to Figure 2A, an integrated circuit structure 200 includes a MIM capacitor having a bottom plate 206, a high-k dielectric layer 204, and a top plate 202. Metal lines 210 and 212 are above and below the MIM capacitor, respectively. MIM contact vias 208 contact the MIM capacitor and the metal lines 210 and 212. In particular, the MIM contact via 208 on the right contacts the bottom plate 206, and the MIM contact via 208 on the left contacts the top plate 202.

To provide further context, in order to achieve higher charge density to reduce the first droop during power switch, state-of-the-art approaches utilize a same high-k material but include (i) a stacking approach (e.g., a multi-plate MIM structure) or (ii) a deep-trench MIM structure to increase the total charge density. Hf-Al-Ox is typically used for high voltage applications (e.g., 1.95V) and Hf-Zr-Ox is typically used for low voltage applications (e.g., 1.25V). However, by using Hf-Zr-Ox for low voltage applications, the MIM leakage current density can be high and capacitor density may be limited by its dielectric constant. Additionally, with respect to an aggressive stacking approach, the gain of charge density is reduced, whereas a deep trench approach can be associated with poor reliability due to complicated structure and high resistance of a thin bottom ALD electrode.

As an exemplary state-of-the-art MIM structure, Figure 2B illustrates a cross-sectional view of an atomic layer deposition (ALD) HfOx-based MIM structure. Referring to Figure 2B, an integrated circuit structure 250 includes a first plate 254, such as a titanium nitride (TiN) layer, is on a dielectric layer 252. A first ALD high-k dielectric layer 256, such as a HfOx layer, is on the first plate 254. A second plate 258, such as a titanium nitride (TiN) layer, is on the first ALD high-k dielectric layer 256. A second ALD high-k dielectric layer 260, such as a HfOx layer, is on the second plate 258. A third plate 262, such as a titanium nitride (TiN) layer, is on the second ALD high-k dielectric layer 260. A first conductive via 264, such as a via coupled to V_{DD}, contacts the second plate 258. A second conductive via 266, such as a via coupled to ground (GND), contacts the first plate 254 and the third plate 262.

In a first aspect, perovskite-based multiple-plate decoupling capacitor structures are described.

In accordance with one or more embodiments of the present disclosure, by using perovskite-based high-k materials, a greater than 2x MIM charge density boost can be achieved of state-of-the-art structures. However, in order to achieve a thermal budget lower than 400 degrees Celsius for backend processing, physical vapor deposition (PVD) sputtering technology is implemented. In accordance with one or more embodiments, PVD perovskite-based multiple-plate decoupling capacitor structures are described.

Advantages for implementing embodiments described herein can include the enablement of circuits/products that have an on-die MIM capacitor to reduce first voltage droop during load switching on microprocessor. A greater than 2x MIM charge density boost can improve circuit performance and operation frequency.

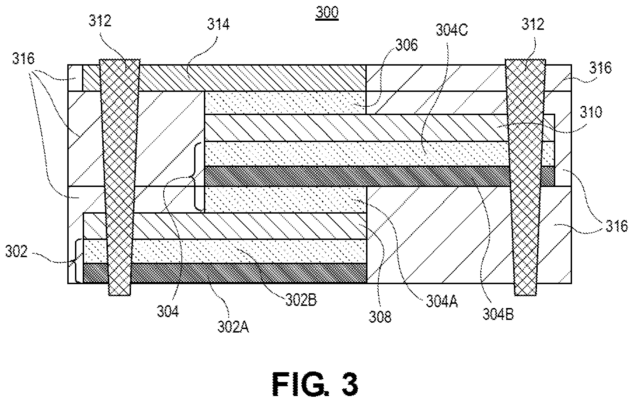

In an embodiment, MIM structures including PVD perovskite-based high-k materials are described. It is to be appreciated that 3-plate MIM structures are depicted, however, the concepts described herein can be extended to multiple-plate MIM structures (e.g., 4, 5, 6-plate MIM). A 2-plate MIM is described as having a structure bottom electrode (BE)/PVD Perovskite/top electrode (TE). As such, three ways to deposit a MIM lead to the three exemplary structures described below in association with Figures 3, 4 and 5: (1) fully in-situ deposition for a 2-plate MIM followed by stacking; (2) air-break between BE and PVD perovskite deposition for a 2-plate MIM followed by stacking; (3) air-break between PVD perovskite and TE deposition followed by stacking.

In a first example which may be formed using a fully in-situ deposition approach, Figure 3 illustrates a PVD perovskite-based multiple-plate decoupling capacitor, in accordance with an embodiment of the present disclosure.

Referring to Figure 3, a metal-insulator-metal (MIM) capacitor 300 includes a first electrode plate 302, and a first capacitor dielectric 308 on the first electrode plate 302. The first electrode plate 302 can include a seeding layer 302A and a conductive electrode layer 302B, as is depicted. The first capacitor dielectric 308 is or includes a perovskite high-k dielectric material, e.g., deposited by a PVD or sputtering approach. A second electrode plate 304 is on the first capacitor dielectric 308 and has a portion over and parallel with the first electrode plate 302. The second electrode plate 304 can include a first conductive electrode layer 304A, a seeding layer 304B, and a second conductive electrode layer 304C, as is depicted. A second capacitor dielectric 310 is on the second electrode plate 304. The second capacitor dielectric 310 is or includes the perovskite high-k dielectric material of first capacitor dielectric 308, e.g., deposited by a PVD or sputtering approach. A third electrode plate 306 is on the second capacitor dielectric 310 and has a portion over and parallel with the second electrode plate 304. An interconnect 314 may be on the third electrode plate 306, as is depicted. A first conductive via (left 312) is coupled to the first electrode plate 302 and to the third electrode plate 306 (e.g., by interconnect 314). A second conductive via (right 312) is coupled to the second electrode plate 304. The MIM structure may be included in one or more dielectric layers 316, such as one or more low-k dielectric layers.

Referring again to Figure 3, in an embodiment, the perovskite high-k dielectric material is one such as but not limited to SrTiO₃, BaTiO₃, and Sr_{X}Ba_{1-X}TiO₃, or BiFeO₃. In an embodiment, the first, second and third electrode plates are composed of a metal layer such as, but not limited to, metal nitrides (TiN or TaN), metal carbides, metal silicides, metal aluminides, hafnium, zirconium, titanium, tantalum, aluminum, ruthenium, palladium, platinum, cobalt, nickel or conductive metal oxides. In an embodiment, the second capacitor dielectric 310 extends laterally beyond the first capacitor dielectric 308, as is depicted. In an embodiment, the first, second and third electrode plates are included in a dielectric material of a back end of line (BEOL) metallization structure, the BEOL metallization structure above a plurality of integrated circuit devices.

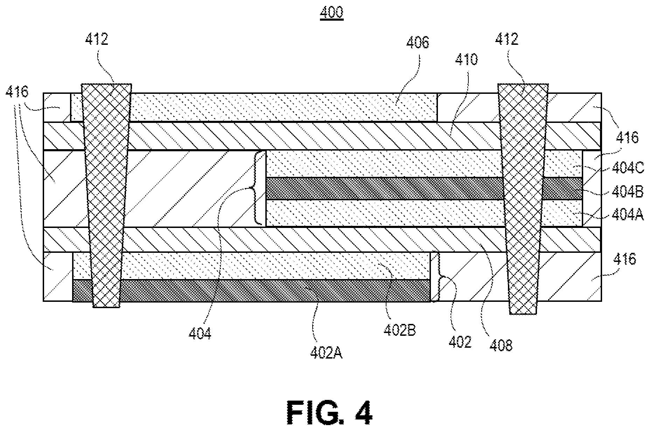

In a second example which may be formed using an air break between bottom electrode and PVD perovskite approach, Figure 4 illustrates another PVD perovskite-based multiple-plate decoupling capacitor, in accordance with another embodiment of the present disclosure.

Referring to Figure 4, a metal-insulator-metal (MIM) capacitor 400 includes a first electrode plate 402, and a first capacitor dielectric 408 on the first electrode plate 402. The first electrode plate 402 can include a seeding layer 402A and a conductive electrode layer 402B, as is depicted. The first capacitor dielectric 408 is or includes a perovskite high-k dielectric material, e.g., deposited by a PVD or sputtering approach. A second electrode plate 404 is on the first capacitor dielectric 408 and has a portion over and parallel with the first electrode plate 402. The second electrode plate 404 can include a first conductive electrode layer 404A, a seeding layer 404B, and a second conductive electrode layer 404C, as is depicted. A second capacitor dielectric 410 is on the second electrode plate 404. The second capacitor dielectric 410 is or includes the perovskite high-k dielectric material of first capacitor dielectric 408, e.g., deposited by a PVD or sputtering approach. A third electrode plate 406 is on the second capacitor dielectric 410 and has a portion over and parallel with the second electrode plate 404. A first conductive via (left 412) is coupled to the first electrode plate 402 and to the third electrode plate 406. A second conductive via (right 412) is coupled to the second electrode plate 404. The MIM structure may be included in one or more dielectric layers 416, such as one or more low-k dielectric layers.

Referring again to Figure 4, in an embodiment, the perovskite high-k dielectric material is selected from the group consisting of SrTiO₃, BaTiO₃, and Sr_{X}Ba_{1-X}TiO₃. In an embodiment, the first, second and third electrode plates are composed of a metal layer such as, but not limited to, metal nitrides (TiN or TaN), metal carbides, metal silicides, metal aluminides, hafnium, zirconium, titanium, tantalum, aluminum, ruthenium, palladium, platinum, cobalt, nickel or conductive metal oxides. In an embodiment, the first, second and third electrode plates are included in a dielectric material of a back end of line (BEOL) metallization structure, the BEOL metallization structure above a plurality of integrated circuit devices.

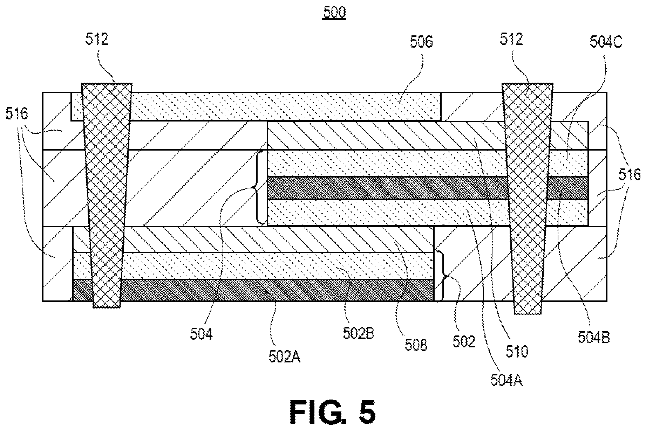

In a third example which may be formed using an air break between perovskite and top electrode approach, Figure 5 illustrates another PVD perovskite-based multiple-plate decoupling capacitor, in accordance with another embodiment of the present disclosure.

Referring to Figure 5, a metal-insulator-metal (MIM) capacitor 500 includes a first electrode plate 502, and a first capacitor dielectric 508 on the first electrode plate 502. The first electrode plate 502 can include a seeding layer 502A and a conductive electrode layer 502B, as is depicted. The first capacitor dielectric 508 is or includes a perovskite high-k dielectric material, e.g., deposited by a PVD or sputtering approach. A second electrode plate 504 is on the first capacitor dielectric 508 and has a portion over and parallel with the first electrode plate 502. The second electrode plate 504 can include a first conductive electrode layer 504A, a seeding layer 504B, and a second conductive electrode layer 504C, as is depicted. A second capacitor dielectric 510 is on the second electrode plate 504. The second capacitor dielectric 510 is or includes the perovskite high-k dielectric material of first capacitor dielectric 508, e.g., deposited by a PVD or sputtering approach. A third electrode plate 506 is on the second capacitor dielectric 510 and has a portion over and parallel with the second electrode plate 504. A first conductive via (left 512) is coupled to the first electrode plate 502 and to the third electrode plate 506. A second conductive via (right 512) is coupled to the second electrode plate 504. The MIM structure may be included in one or more dielectric layers 516, such as one or more low-k dielectric layers.

Referring again to Figure 5, in an embodiment, the perovskite high-k dielectric material is selected from the group consisting of SrTiO₃, BaTiO₃, and Sr_{X}Ba_{1-X}TiO₃. In an embodiment, the first, second and third electrode plates are composed of a metal layer such as, but not limited to, metal nitrides (TiN or TaN), metal carbides, metal silicides, metal aluminides, hafnium, zirconium, titanium, tantalum, aluminum, ruthenium, palladium, platinum, cobalt, nickel or conductive metal oxides. In an embodiment, the second capacitor dielectric 510 extends laterally beyond the first capacitor dielectric 508, as is depicted. In an embodiment, the first, second and third electrode plates are included in a dielectric material of a back end of line (BEOL) metallization structure, the BEOL metallization structure above a plurality of integrated circuit devices.

In a second aspect, hybrid PVD perovskite based and ALD based decoupling capacitor structures are described.

In accordance with an embodiment of the present disclosure, a hybrid PVD perovskite based and ALD based decoupling capacitor structure is fabricated to achieve high capacitance density from low voltage to high voltage. Embodiments can be implemented to provide a hybrid PVD perovskite based MIM for low voltage applications (e.g., less than 1.5V) and a ALD based decoupling capacitor structure for high voltage applications (e.g., greater than 1.5V). As mentioned above, PVD Perovskite based MIM has a very high dielectric constant compared to ALD HfOx based materials. However, PVD perovskite based MIM is based on a polar material, so capacitance density may become lower at high voltage.

In an embodiment, a hybrid PVD perovskite based and ALD high-k based decoupling capacitor structure is implemented for both high voltage and low voltage applications. The structure may enable a maximum capacitance density realization from low to high voltage applications.

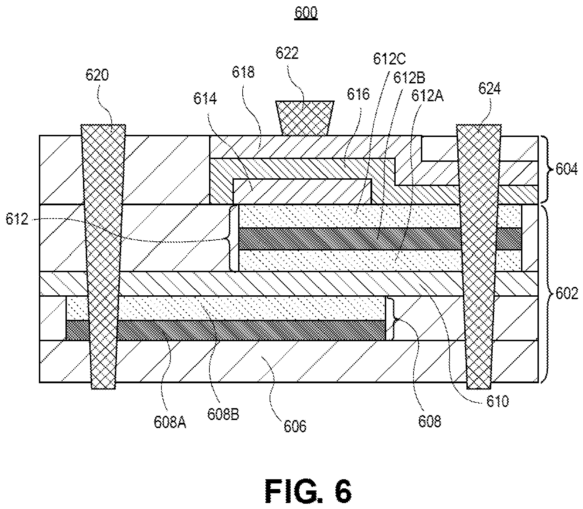

As an exemplary hybrid structure, Figure 6 illustrates a hybrid PVD perovskite-based and ALD non-perovskite-based multiple-plate decoupling capacitor, in accordance with an embodiment of the present disclosure.

Referring to Figure 6, a metal-insulator-metal (MIM) capacitor 600 has a first voltage region 602 different from a second voltage region 604. The MIM capacitor 600 includes a first electrode plate 608 on a dielectric layer 606. The first electrode plate 608 can include a seeding layer 608A and a conductive electrode layer 608B, as is depicted. A first capacitor dielectric 610 is on the first electrode plate 608. The first capacitor dielectric 610 is or includes a perovskite high-k dielectric material, e.g., deposited by a PVD or sputtering approach. A second electrode plate 612 is on the first capacitor dielectric 610 and has a portion over and parallel with the first electrode plate 608. The second electrode plate 612 can include a first conductive electrode layer 612A, a seeding layer 612B, and a second conductive electrode layer 612C, as is depicted. A conductive pedestal 614, such as a TiN pedestal, is on a portion of the second electrode plate 612. A second capacitor dielectric 616 is on the conductive pedestal 614 and on the second electrode plate 612. The second capacitor dielectric 616 is or includes a non-perovskite high-k dielectric material, e.g., deposited by an ALD. A third electrode plate 618 is on the second capacitor dielectric 616 and has a portion over and parallel with the second electrode plate 612. A first conductive via (left 620, e.g., low _{VDD}) is coupled to the first electrode plate 608. A second conductive via (right 612, e.g., GND) is coupled to the second electrode plate 612 and, possibly, to the third electrode plate 618. A contact or tap 622 (e.g., high V_{DD}) is coupled to the third electrode plate 618. The MIM structure may be included in one or more dielectric layers, such as one or more low-k dielectric layers.

Referring again to Figure 6, in an embodiment, the perovskite high-k dielectric material is selected from the group consisting of SrTiO₃, BaTiO₃, and Sr_{X}Ba_{1-X}TiO₃. In an embodiment, the non-perovskite high-k dielectric material is selected from the group consisting of hafnium oxide, hafnium, hafnium zirconium oxide, and hafnium aluminum oxide. In an embodiment, the first, second and third electrode plates are composed of a metal layer such as, but not limited to, metal nitrides (TiN or TaN), metal carbides, metal silicides, metal aluminides, hafnium, zirconium, titanium, tantalum, aluminum, ruthenium, palladium, platinum, cobalt, nickel or conductive metal oxides. In an embodiment, the first, second and third electrode plates are included in a dielectric material of a back end of line (BEOL) metallization structure, the BEOL metallization structure above a plurality of integrated circuit devices.

It is to be appreciated that, although the structure of Figure 6 depicts the non-perovskite high-k dielectric material as being above the perovskite high-k dielectric material, in other arrangements, the perovskite high-k dielectric material is above the non-perovskite high-k dielectric material. It is also to be appreciated that in other embodiments, one of the perovskite high-k dielectric material layers in the structures of Figures 3, 4 or 5 can be replaced with an ALD non-perovskite high-k dielectric material to provide a hybrid MIM structure.

In another aspect, one or more embodiments are directed to the use of a scalable and configurable parallel plate capacitor layering scheme in order to provide industry leading MIM capacitive densities, without compromising the reliability of the final device. Such a scaling method can be used to increase cap density without an area impact and can enhance existing designed layouts without extra design overhead. Increasing MIM capacitance provides a significant performance improvement.

To provide context, advanced transistor scaling requires an advanced and stable power delivery method. Decoupling capacitors are employed to minimize impedance and power supply noise. This has been leveraged in past by incorporating a metal-insulator-metal (MIM) capacitor in the interconnect stack as depicted in Figure 2A, described above. Higher overall total capacitance in such MIM capacitors can more effectively mitigate voltage droop and current ripples to the transistor and thereby enhance the overall performance of the final device.

It is to be appreciated that one or more embodiments described above are 3-plate MIM capacitor structures. It is to be appreciated that the addition of an enhanced total capacitance can translate to improved device performance. In accordance with one or more embodiments of the present disclosure, total MIM cap density is increased by use of a scalable and configurable parallel plate capacitor layering scheme where the total number of electrode plates/capacitors in parallel increase from 3 to 4 or 5 (or more) in total. In embodiments described herein, one or two (or even more) additional electrode/capacitor pairs are added to the stack in parallel.

Advantages of implementing embodiments described herein can include promoting higher dielectric constants and higher breakdown voltages and large charge storage in the MIM capacitors. Higher capacitance MIM structures compensate for droops in power delivery and buffer external electrical noise sources. The result can mean lower Vmin for the transistor, which can be utilized to operate at substantially higher operational frequencies and/or at lower power.

In another aspect, back end of line (BEOL) layers of integrated circuits commonly include electrically conductive microelectronic structures, which are known in the art as vias, to electrically connect metal lines or other interconnects above the vias to metal lines or other interconnects below the vias. In accordance with one or more embodiments of the present disclosure, a metal insulator metal (MIM) capacitor such as described above can be included a BEOL structure of an integrated circuit.

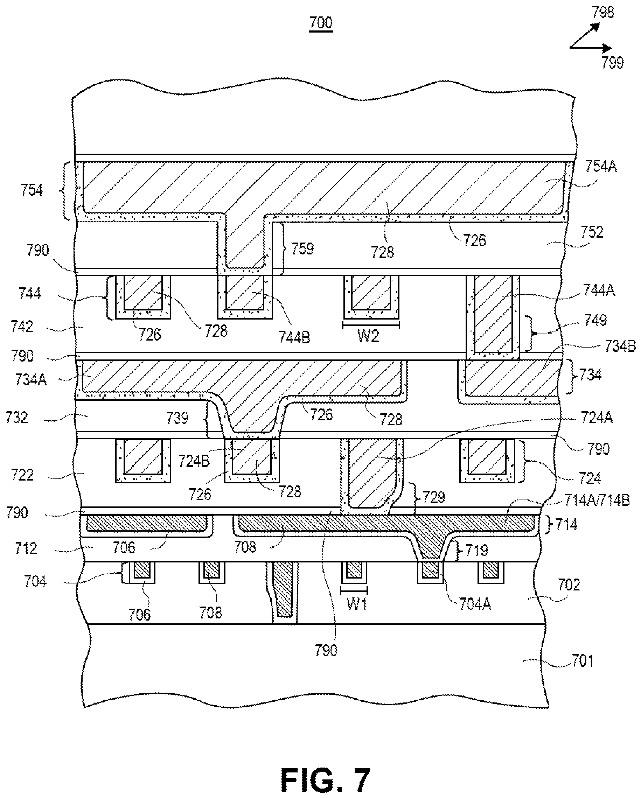

As an exemplary but non-limiting BEOL structure, Figure 7 illustrates a cross-sectional view of an integrated circuit structure having four metallization layers with a metal line composition and pitch above two metallization layers with a differing metal line composition and smaller pitch, in accordance with an embodiment of the present disclosure. It is to be appreciated that a metal insulator metal (MIM) capacitor according to embodiments described above may be integrated into one or more layers of the integrated circuit structure described below in association with Figure 7.

Referring to Figure 7, an integrated circuit structure 700 includes a first plurality of conductive interconnect lines 704 in and spaced apart by a first inter-layer dielectric (ILD) layer 702 above a substrate 701. Individual ones of the first plurality of conductive interconnect lines 704 include a first conductive barrier material 706 along sidewalls and a bottom of a first conductive fill material 708. Individual ones of the first plurality of conductive interconnect lines 704 are along a first direction 798 (e.g., into and out of the page).

A second plurality of conductive interconnect lines 714 is in and spaced apart by a second ILD layer 712 above the first ILD layer 702. Individual ones of the second plurality of conductive interconnect lines 714 include the first conductive barrier material 706 along sidewalls and a bottom of the first conductive fill material 708. Individual ones of the second plurality of conductive interconnect lines 714 are along a second direction 799 orthogonal to the first direction 798.

A third plurality of conductive interconnect lines 724 is in and spaced apart by a third ILD layer 722 above the second ILD layer 712. Individual ones of the third plurality of conductive interconnect lines 724 include a second conductive barrier material 726 along sidewalls and a bottom of a second conductive fill material 728. The second conductive fill material 728 is different in composition from the first conductive fill material 708. Individual ones of the third plurality of conductive interconnect lines 724 are along the first direction 798.

A fourth plurality of conductive interconnect lines 734 is in and spaced apart by a fourth ILD layer 732 above the third ILD layer 722. Individual ones of the fourth plurality of conductive interconnect lines 734 include the second conductive barrier material 726 along sidewalls and a bottom of the second conductive fill material 728. Individual ones of the fourth plurality of conductive interconnect lines 734 are along the second direction 799.

A fifth plurality of conductive interconnect lines 744 is in and spaced apart by a fifth ILD layer 742 above the fourth ILD layer 732. Individual ones of the fifth plurality of conductive interconnect lines 744 include the second conductive barrier material 726 along sidewalls and a bottom of the second conductive fill material 728. Individual ones of the fifth plurality of conductive interconnect lines 744 are along the first direction 798.

A sixth plurality of conductive interconnect lines 754 is in and spaced apart by a sixth ILD layer 752 above the fifth ILD layer 742. Individual ones of the sixth plurality of conductive interconnect lines 754 include the second conductive barrier material 726 along sidewalls and a bottom of the second conductive fill material 728. Individual ones of the sixth plurality of conductive interconnect lines 754 are along the second direction 799.

In an embodiment, the second conductive fill material 728 consists essentially of copper, and the first conductive fill material 708 consists essentially of cobalt. In an embodiment, the first conductive fill material 708 includes copper having a first concentration of a dopant impurity atom, and the second conductive fill material 728 includes copper having a second concentration of the dopant impurity atom, the second concentration of the dopant impurity atom less than the first concentration of the dopant impurity atom.

In an embodiment, the first conductive barrier material 706 is different in composition from the second conductive barrier material 726. In another embodiment, the first conductive barrier material 706 and the second conductive barrier material 726 have the same composition.

In an embodiment, a first conductive via 719 is on and electrically coupled to an individual one 704A of the first plurality of conductive interconnect lines 704. An individual one 714A of the second plurality of conductive interconnect lines 714 is on and electrically coupled to the first conductive via 719.

A second conductive via 729 is on and electrically coupled to an individual one 714B of the second plurality of conductive interconnect lines 714. An individual one 724A of the third plurality of conductive interconnect lines 724 is on and electrically coupled to the second conductive via 729.

A third conductive via 739 is on and electrically coupled to an individual one 724B of the third plurality of conductive interconnect lines 724. An individual one 734A of the fourth plurality of conductive interconnect lines 734 is on and electrically coupled to the third conductive via 739.

A fourth conductive via 749 is on and electrically coupled to an individual one 734B of the fourth plurality of conductive interconnect lines 734. An individual one 744A of the fifth plurality of conductive interconnect lines 744 is on and electrically coupled to the fourth conductive via 749.

A fifth conductive via 759 is on and electrically coupled to an individual one 744B of the fifth plurality of conductive interconnect lines 744. An individual one 754A of the sixth plurality of conductive interconnect lines 754 is on and electrically coupled to the fifth conductive via 759.

In one embodiment, the first conductive via 719 includes the first conductive barrier material 706 along sidewalls and a bottom of the first conductive fill material 708. The second 729, third 739, fourth 749 and fifth 759 conductive vias include the second conductive barrier material 726 along sidewalls and a bottom of the second conductive fill material 728.

In an embodiment, the first 702, second 712, third 722, fourth 732, fifth 742 and sixth 752 ILD layers are separated from one another by a corresponding etch-stop layer 790 between adjacent ILD layers. In an embodiment, the first 702, second 712, third 722, fourth 732, fifth 742 and sixth 752 ILD layers include silicon, carbon and oxygen.

In an embodiment, individual ones of the first 704 and second 714 pluralities of conductive interconnect lines have a first width (W1). Individual ones of the third 724, fourth 734, fifth 744 and sixth 754 pluralities of conductive interconnect lines have a second width (W2) greater than the first width (W1).

It is to be appreciated that the layers and materials described above in association with back end of line (BEOL) structures and processing may be formed on or above an underlying semiconductor substrate or structure, such as underlying device layer(s) of an integrated circuit. In an embodiment, an underlying semiconductor substrate represents a general workpiece object used to manufacture integrated circuits. The semiconductor substrate often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as substrates including germanium, carbon, or group III-V materials. The semiconductor substrate, depending on the stage of manufacture, often includes transistors, integrated circuitry, and the like. The substrate may also include semiconductor materials, metals, dielectrics, dopants, and other materials commonly found in semiconductor substrates. Furthermore, the structures depicted may be fabricated on underlying lower level interconnect layers.

Although the preceding methods of fabricating a metallization layer, or portions of a metallization layer, of a BEOL metallization layer are described in detail with respect to select operations, it is to be appreciated that additional or intermediate operations for fabrication may include standard microelectronic fabrication processes such as lithography, etch, thin films deposition, planarization (such as chemical mechanical polishing (CMP)), diffusion, metrology, the use of sacrificial layers, the use of etch stop layers, the use of planarization stop layers, or any other associated action with microelectronic component fabrication. Also, it is to be appreciated that the process operations described for the preceding process flows may be practiced in alternative sequences, not every operation need be performed or additional process operations may be performed or both.

In an embodiment, as used throughout the present description, interlayer dielectric (ILD) material is composed of or includes a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, various low-k dielectric materials known in the arts, and combinations thereof. The interlayer dielectric material may be formed by techniques, such as, for example, chemical vapor deposition (CVD), physical vapor deposition (PVD), or by other deposition methods.

In an embodiment, as is also used throughout the present description, metal lines or interconnect line material (and via material) is composed of one or more metal or other conductive structures. A common example is the use of copper lines and structures that may or may not include barrier layers between the copper and surrounding ILD material. As used herein, the term metal includes alloys, stacks, and other combinations of multiple metals. For example, the metal interconnect lines may include barrier layers (e.g., layers including one or more of Ta, TaN, Ti or TiN), stacks of different metals or alloys, etc. Thus, the interconnect lines may be a single material layer, or may be formed from several layers, including conductive liner layers and fill layers. Any suitable deposition process, such as electroplating, chemical vapor deposition or physical vapor deposition, may be used to form interconnect lines. In an embodiment, the interconnect lines are composed of a conductive material such as, but not limited to, Cu, Al, Ti, Zr, Hf, V, Ru, Co, Ni, Pd, Pt, W, Ag, Au or alloys thereof. The interconnect lines are also sometimes referred to in the art as traces, wires, lines, metal, or simply interconnect.

In an embodiment, as is also used throughout the present description, hardmask materials are composed of dielectric materials different from the interlayer dielectric material. In one embodiment, different hardmask materials may be used in different regions so as to provide different growth or etch selectivity to each other and to the underlying dielectric and metal layers. In some embodiments, a hardmask layer includes a layer of a nitride of silicon (e.g., silicon nitride) or a layer of an oxide of silicon, or both, or a combination thereof. Other suitable materials may include carbon-based materials. In another embodiment, a hardmask material includes a metal species. For example, a hardmask or other overlying material may include a layer of a nitride of titanium or another metal (e.g., titanium nitride). Potentially lesser amounts of other materials, such as oxygen, may be included in one or more of these layers. Alternatively, other hardmask layers known in the arts may be used depending upon the particular implementation. The hardmask layers maybe formed by CVD, PVD, or by other deposition methods.

In an embodiment, as is also used throughout the present description, lithographic operations are performed using 193nm immersion lithography (i193), extreme ultra-violet (EUV) lithography or electron beam direct write (EBDW) lithography, or the like. A positive tone or a negative tone resist may be used. In one embodiment, a lithographic mask is a trilayer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

Embodiments disclosed herein may be used to manufacture a wide variety of different types of integrated circuits or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

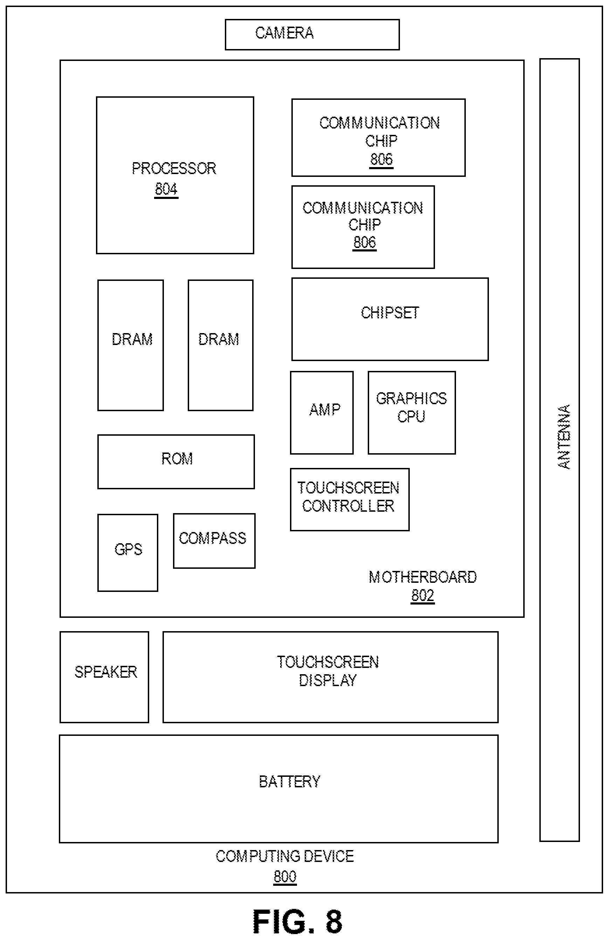

Figure 8 illustrates a computing device 800 in accordance with one implementation of the disclosure. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

Depending on its applications, computing device 800 may include other components that may or may not be physically and electrically coupled to the board 802. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of embodiments of the disclosure, the integrated circuit die of the processor includes one or more structures, such as a metal insulator metal (MIM) capacitor built in accordance with implementations of the disclosure. The term "processor" may refer to any device or portion of a device that processes electronic data from registers or memory to transform that electronic data, or both, into other electronic data that may be stored in registers or memory, or both.

The communication chip 806 also includes an integrated circuit die packaged within the communication chip 806. In accordance with another implementation of the disclosure, the integrated circuit die of the communication chip has a metal insulator metal (MIM) capacitor built in accordance with implementations of the disclosure.

In further implementations, another component housed within the computing device 800 may contain an integrated circuit die having a metal insulator metal (MIM) capacitor built in accordance with implementations of embodiments of the disclosure.

In various embodiments, the computing device 800 may be a laptop, a netbook, a notebook, an ultrabook, a smartphone, a tablet, a personal digital assistant (PDA), an ultramobile PC, a mobile phone, a desktop computer, a server, a printer, a scanner, a monitor, a set-top box, an entertainment control unit, a digital camera, a portable music player, or a digital video recorder. In further implementations, the computing device 800 may be any other electronic device that processes data.

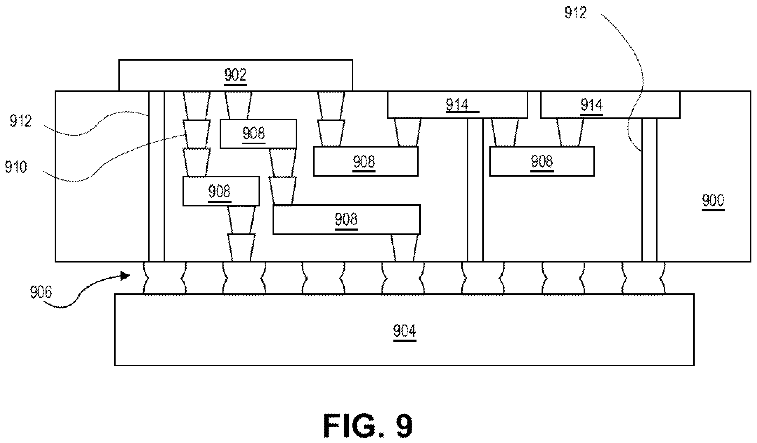

Figure 9 illustrates an interposer 900 that includes one or more embodiments of the disclosure. The interposer 900 is an intervening substrate used to bridge a first substrate 902 to a second substrate 904. The first substrate 902 may be, for instance, an integrated circuit die. The second substrate 904 may be, for instance, a memory module, a computer motherboard, or another integrated circuit die. Generally, the purpose of an interposer 900 is to spread a connection to a wider pitch or to reroute a connection to a different connection. For example, an interposer 900 may couple an integrated circuit die to a ball grid array (BGA) 906 that can subsequently be coupled to the second substrate 904. In some embodiments, the first and second substrates 902/904 are attached to opposing sides of the interposer 900. In other embodiments, the first and second substrates 902/904 are attached to the same side of the interposer 900. And, in further embodiments, three or more substrates are interconnected by way of the interposer 900.

The interposer 900 may be formed of an epoxy resin, a fiberglass-reinforced epoxy resin, a ceramic material, or a polymer material such as polyimide. In further implementations, the interposer 900 may be formed of alternate rigid or flexible materials that may include the same materials described above for use in a semiconductor substrate, such as silicon, germanium, and other group III-V and group IV materials.

The interposer 900 may include metal interconnects 908 and vias 910, including but not limited to through-silicon vias (TSVs) 912. The interposer 900 may further include embedded devices 914, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 900. In accordance with embodiments of the disclosure, apparatuses or processes disclosed herein may be used in the fabrication of interposer 900 or in the fabrication of components included in the interposer 900.

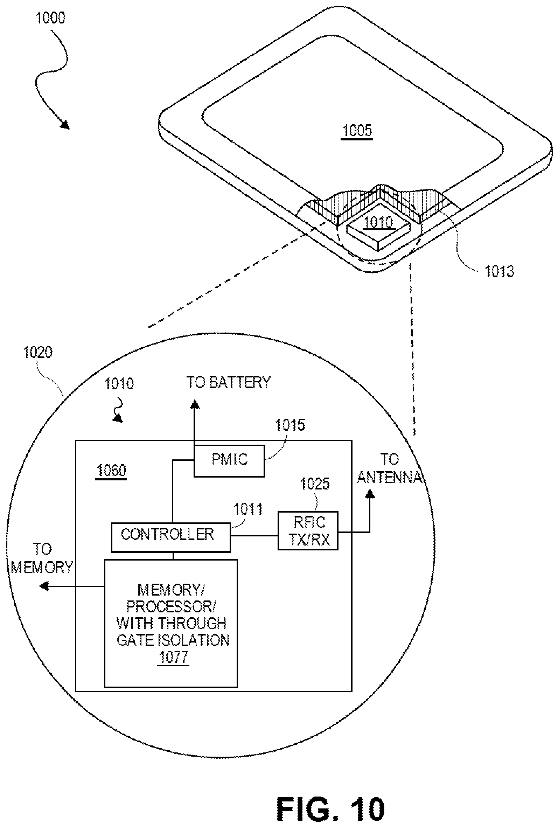

Figure 10 is an isometric view of a mobile computing platform 1000 employing an integrated circuit (IC) fabricated according to one or more processes described herein or including one or more features described herein, in accordance with an embodiment of the present disclosure.

The mobile computing platform 1000 may be any portable device configured for each of electronic data display, electronic data processing, and wireless electronic data transmission. For example, mobile computing platform 1000 may be any of a tablet, a smart phone, laptop computer, etc. and includes a display screen 1005 which in the exemplary embodiment is a touchscreen (capacitive, inductive, resistive, etc.), a chip-level (SoC) or package-level integrated system 1010, and a battery 1013. As illustrated, the greater the level of integration in the system 1010 enabled by higher transistor packing density, the greater the portion of the mobile computing platform 1000 that may be occupied by the battery 1013 or non-volatile storage, such as a solid state drive, or the greater the transistor gate count for improved platform functionality. Similarly, the greater the carrier mobility of each transistor in the system 1010, the greater the functionality. As such, techniques described herein may enable performance and form factor improvements in the mobile computing platform 1000.

The integrated system 1010 is further illustrated in the expanded view 1020. In the exemplary embodiment, packaged device 1077 includes at least one memory chip (e.g., RAM), or at least one processor chip (e.g., a multi-core microprocessor and/or graphics processor) fabricated according to one or more processes described herein or including one or more features described herein. The packaged device 1077 is further coupled to the board 1060 along with one or more of a power management integrated circuit (PMIC) 1015, RF (wireless) integrated circuit (RFIC) 1025 including a wideband RF (wireless) transmitter and/or receiver (e.g., including a digital baseband and an analog front end module further includes a power amplifier on a transmit path and a low noise amplifier on a receive path), and a controller thereof 1011. Functionally, the PMIC 1015 performs battery power regulation, DC-to-DC conversion, etc., and so has an input coupled to the battery 1013 and with an output providing a current supply to all the other functional modules. As further illustrated, in the exemplary embodiment, the RFIC 1025 has an output coupled to an antenna to provide to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. In alternative implementations, each of these board-level modules may be integrated onto separate ICs coupled to the package substrate of the packaged device 1077 or within a single IC (SoC) coupled to the package substrate of the packaged device 1077.

In another aspect, semiconductor packages are used for protecting an integrated circuit (IC) chip or die, and also to provide the die with an electrical interface to external circuitry. With the increasing demand for smaller electronic devices, semiconductor packages are designed to be even more compact and must support larger circuit density. Furthermore, the demand for higher performance devices results in a need for an improved semiconductor package that enables a thin packaging profile and low overall warpage compatible with subsequent assembly processing.

In an embodiment, wire bonding to a ceramic or organic package substrate is used. In another embodiment, a C4 process is used to mount a die to a ceramic or organic package substrate. In particular, C4 solder ball connections can be implemented to provide flip chip interconnections between semiconductor devices and substrates. A flip chip or Controlled Collapse Chip Connection (C4) is a type of mounting used for semiconductor devices, such as integrated circuit (IC) chips, MEMS or components, which utilizes solder bumps instead of wire bonds. The solder bumps are deposited on the C4 pads, located on the top side of the substrate package. In order to mount the semiconductor device to the substrate, it is flipped over with the active side facing down on the mounting area. The solder bumps are used to connect the semiconductor device directly to the substrate.

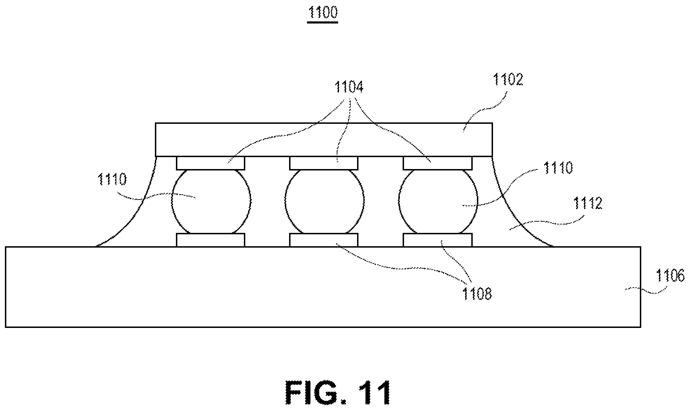

Figure 11 illustrates a cross-sectional view of a flip-chip mounted die, in accordance with an embodiment of the present disclosure.

Referring to Figure 11, an apparatus 1100 includes a die 1102 such as an integrated circuit (IC) fabricated according to one or more processes described herein or including one or more features described herein, in accordance with an embodiment of the present disclosure. The die 1102 includes metallized pads 1104 thereon. A package substrate 1106, such as a ceramic or organic substrate, includes connections 1108 thereon. The die 1102 and package substrate 1106 are electrically connected by solder balls 1110 coupled to the metallized pads 1104 and the connections 1108. An underfill material 1112 surrounds the solder balls 1110.

Processing a flip chip may be similar to conventional IC fabrication, with a few additional operations. Near the end of the manufacturing process, the attachment pads are metalized to make them more receptive to solder. This typically consists of several treatments. A small dot of solder is then deposited on each metalized pad. The chips are then cut out of the wafer as normal. To attach the flip chip into a circuit, the chip is inverted to bring the solder dots down onto connectors on the underlying electronics or circuit board. The solder is then re-melted to produce an electrical connection, typically using an ultrasonic or alternatively reflow solder process. This also leaves a small space between the chip's circuitry and the underlying mounting. In most cases an electrically-insulating adhesive is then "underfilled" to provide a stronger mechanical connection, provide a heat bridge, and to ensure the solder joints are not stressed due to differential heating of the chip and the rest of the system.

In other embodiments, newer packaging and die-to-die interconnect approaches, such as through silicon via (TSV) and silicon interposer, are implemented to fabricate high performance Multi-Chip Module (MCM) and System in Package (SiP) incorporating an integrated circuit (IC) fabricated according to one or more processes described herein or including one or more features described herein, in accordance with an embodiment of the present disclosure.

Thus, embodiments of the present disclosure include metal insulator metal (MIM) capacitors.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise. The above description is intended to cover such alternatives, modifications, and equivalents as would be apparent to a person skilled in the art having the benefit of the present disclosure.

The scope of the present disclosure includes any feature or combination of features disclosed herein (either explicitly or implicitly), or any generalization thereof, whether or not it mitigates any or all of the problems addressed herein. Accordingly, new claims may be formulated during prosecution of the present application (or an application claiming priority thereto) to any such combination of features. In particular, with reference to the appended claims, features from dependent claims may be combined with those of the independent claims and features from respective independent claims may be combined in any appropriate manner and not merely in the specific combinations enumerated in the appended claims.

The following examples pertain to further embodiments. The various features of the different embodiments may be variously combined with some features included and others excluded to suit a variety of different applications.

Example embodiment 1: A metal-insulator-metal (MIM) capacitor includes a first electrode plate, and a first capacitor dielectric on the first electrode plate. The first capacitor dielectric is or includes a perovskite high-k dielectric material. A second electrode plate is on the first capacitor dielectric and has a portion over and parallel with the first electrode plate, and a second capacitor dielectric is on the second electrode plate. The second capacitor dielectric is or includes the perovskite high-k dielectric material. A third electrode plate is on the second capacitor dielectric and has a portion over and parallel with the second electrode plate.

Example embodiment 2: The MIM capacitor of example embodiment 1, wherein the perovskite high-k dielectric material is selected from the group consisting of SrTiO₃, BaTiO₃, and Sr_{X}Ba_{1-X}TiO₃.

Example embodiment 3: The MIM capacitor of example embodiment 1 or 2, wherein the second capacitor dielectric extends laterally beyond the first capacitor dielectric.

Example embodiment 4: The MIM capacitor of example embodiment 1, 2 or 3, wherein the first, second and third electrode plates are included in a dielectric material.

Example embodiment 5: The MIM capacitor of example embodiment 4, wherein the dielectric material is included in a back end of line (BEOL) metallization structure, the BEOL metallization structure above a plurality of integrated circuit devices.

Example embodiment 6: A metal-insulator-metal (MIM) capacitor includes a first electrode plate, and a first capacitor dielectric on the first electrode plate. The first capacitor dielectric is or includes a perovskite high-k dielectric material. A second electrode plate is on the first capacitor dielectric and has a portion over and parallel with the first electrode plate, and a second capacitor dielectric is on the second electrode plate. The second capacitor dielectric is or includes a non-perovskite high-k dielectric material. A third electrode plate is on the second capacitor dielectric and has a portion over and parallel with the second electrode plate.

Example embodiment 7: The MIM capacitor of example embodiment 6, wherein the perovskite high-k dielectric material is selected from the group consisting of SrTiO₃, BaTiO₃, and Sr_{X}Ba_{1-X}TiO₃.

Example embodiment 8: The MIM capacitor of example embodiment 6 or 7, wherein the non-perovskite high-k dielectric material is selected from the group consisting of hafnium oxide, hafnium zirconium oxide, and hafnium aluminum oxide.

Example embodiment 9: The MIM capacitor of example embodiment 6, 7 or 8, wherein the first, second and third electrode plates are included in a dielectric material.

Example embodiment 10: The MIM capacitor of example embodiment 9, wherein the dielectric material is included in a back end of line (BEOL) metallization structure, the BEOL metallization structure above a plurality of integrated circuit devices.

Example embodiment 11: A computing device includes a board, and a component coupled to the board. The component includes a metal-insulator-metal (MIM) capacitor including a first electrode plate, and a first capacitor dielectric on the first electrode plate. The first capacitor dielectric is or includes a perovskite high-k dielectric material. A second electrode plate is on the first capacitor dielectric and has a portion over and parallel with the first electrode plate, and a second capacitor dielectric is on the second electrode plate. The second capacitor dielectric is or includes the perovskite high-k dielectric material. A third electrode plate is on the second capacitor dielectric and has a portion over and parallel with the second electrode plate.

Example embodiment 12: The computing device of example embodiment 11, further including a memory coupled to the board.

Example embodiment 13: The computing device of example embodiment 11 or 12, further including a communication chip coupled to the board.

Example embodiment 14: The computing device of example embodiment 11, 12 or 13, further including a camera coupled to the board.

Example embodiment 15: The computing device of example embodiment 11, 12, 13 or 14, wherein the component is a packaged integrated circuit die.

Example embodiment 16: A computing device includes a board, and a component coupled to the board. The component includes a metal-insulator-metal (MIM) capacitor including a first electrode plate, and a first capacitor dielectric on the first electrode plate. The first capacitor dielectric is or includes a perovskite high-k dielectric material. A second electrode plate is on the first capacitor dielectric and has a portion over and parallel with the first electrode plate, and a second capacitor dielectric is on the second electrode plate. The second capacitor dielectric is or includes a non-perovskite high-k dielectric material. A third electrode plate is on the second capacitor dielectric and has a portion over and parallel with the second electrode plate.

Example embodiment 17: The computing device of example embodiment 16, further including a memory coupled to the board.

Example embodiment 18: The computing device of example embodiment 16 or 17, further including a communication chip coupled to the board.

Example embodiment 19: The computing device of example embodiment 16, 17 or 18, further including a camera coupled to the board.

Example embodiment 20: The computing device of example embodiment 16, 17, 18 or 19, wherein the component is a packaged integrated circuit die.

## Claims

1. A metal-insulator-metal (MIM) capacitor, comprising:
a first electrode plate;
a first capacitor dielectric on the first electrode plate, the first capacitor dielectric comprising a perovskite high-k dielectric material;
a second electrode plate on the first capacitor dielectric, the second electrode plate having a portion over and parallel with the first electrode plate;
a second capacitor dielectric on the second electrode plate, the second capacitor dielectric comprising the perovskite high-k dielectric material; and
a third electrode plate on the second capacitor dielectric, the third electrode plate having a portion over and parallel with the second electrode plate.

2. The MIM capacitor of claim 1, wherein the perovskite high-k dielectric material is selected from the group consisting of SrTiO₃, BaTiO₃, and Sr_{X}Ba_{1-X}TiO₃.

3. The MIM capacitor of claim 1 or 2, wherein the second capacitor dielectric extends laterally beyond the first capacitor dielectric.

4. The MIM capacitor of claim 1, 2 or 3, wherein the first, second and third electrode plates are included in a dielectric material.

5. The MIM capacitor of claim 4, wherein the dielectric material is included in a back end of line (BEOL) metallization structure, the BEOL metallization structure above a plurality of integrated circuit devices.

6. A method of fabricating a metal-insulator-metal (MIM) capacitor, the method comprising:
forming a first electrode plate;
forming a first capacitor dielectric on the first electrode plate, the first capacitor dielectric comprising a perovskite high-k dielectric material;
forming a second electrode plate on the first capacitor dielectric, the second electrode plate having a portion over and parallel with the first electrode plate;
forming a second capacitor dielectric on the second electrode plate, the second capacitor dielectric comprising the perovskite high-k dielectric material; and
forming a third electrode plate on the second capacitor dielectric, the third electrode plate having a portion over and parallel with the second electrode plate.

7. The method of claim 6, wherein the perovskite high-k dielectric material is selected from the group consisting of SrTiO₃, BaTiO₃, and Sr_{X}Ba_{1-X}TiO₃.

8. The method of claim 6 or 7, wherein the second capacitor dielectric extends laterally beyond the first capacitor dielectric.

9. The method of claim 6, 7 or 8, wherein the first, second and third electrode plates are included in a dielectric material.

10. The method of claim 9, wherein the dielectric material is included in a back end of line (BEOL) metallization structure, the BEOL metallization structure above a plurality of integrated circuit devices.
